# EUROPÄISCHE PATENTSCHRIFT

(11) **EP 3 944 120 B1**
(45) Veröffentlichungstag und Bekanntmachung des Hinweises auf die Patenterteilung: **01.11.2023**
(21) Anmeldenummer: 21186769.2
(22) Anmeldetag: 20.07.2021
(51) Int. Cl.: G06F 30/13, B26D 5/00, B28D 7/00, B26F 1/38

(54) **VERFAHREN ZUR BESTIMMUNG VON ZUSCHNITTPARAMETERN FÜR PLATTEN UND VERFAHREN ZUR HERSTELLUNG VON TAFELN FÜR EINE VERTÄFELUNG EINER FLÄCHE**
METHOD FOR THE DETERMINATION OF BLANK PARAMETERS FOR PANELS AND METHOD FOR PRODUCING PANELS FOR THE PANELLING OF A SURFACE
PROCÉDÉ DE DÉTERMINATION DES PARAMÈTRES DE COUPE POUR PANNEAUX ET PROCÉDÉ DE FABRICATION DE PANNEAUX POUR UN ASSEMBLAGE D'UNE SURFACE

(30) Priorität: 20.07.2020 DE 102020004351
(43) Veröffentlichungstag der Anmeldung: 26.01.2022
(73) Patentinhaber: artEmotional GmbH, 77955 Ettenheim (DE)
(72) Erfinder: Nabbefeld, Jonas, 79650 Schopfheim (DE); Bangert, Dennis, 80805 München (DE); Keller, Jan-Peter, 77955 Ettenheim (DE)
(74) Vertreter: Mertzlufft-Paufler, Cornelius

(56) Entgegenhaltungen:
- CN-A- 109 727 281
- US-A1- 2007 282 718
- US-A1- 2020 004 222

## Beschreibung

Die Erfindung betrifft ein Verfahren zur Bestimmung von Zuschnittparametern für Platten, insbesondere für Steinplatten. Die Erfindung betrifft ferner ein Verfahren zur Herstellung von Tafeln für eine Vertäfelung einer Fläche. Bei der Fläche kann es sich beispielsweise um einen Boden, eine Wand oder eine Decke handeln. Bei den Tafeln kann es sich beispielsweise um Fliesen, Kacheln, Paneele oder dergleichen handeln.

Soll beispielsweise ein Steinboden verlegt werden, wird aktuell häufig wie folgt beschrieben vorgegangen. In einem Steinbruch wird der herausgelöste Stein in Steinplatten zerlegt, die häufig eine Größe von etwa 2x3 Meter haben und bis zu einer Tonne wiegen können.

Aus diesen Steinplatten werden kleinere Steinfliesen herausgeschnitten, die später am Verlegungsort verlegt werden. Für diesen Zuschnitt der Platten ist es zunächst erforderlich, Zuschnittparameter zu bestimmen, die insbesondere die Form und Größe der zuzuschneidenden Tafeln umfassen können sowie den Zuschnittsort auf der Platte.

Vor der finalen Verlegung wird häufig ein weiterer Verfahrensschritt durchgeführt, bei dem die Steinfliesen zunächst trocken ausgelegt werden. Es wird sodann von einem Experten geprüft, ob die ausgelegte Anordnung den ästhetischen Erwartungen entspricht oder ob Steinfliesen ausgetauscht oder umgeordnet werden sollen. Dieser Vorgang ist auch als Blending bekannt. In seiner aktuellen Form ist dieser Verfahrensschritt aufwändig und kostenintensiv.

Aus der US 2020/004222 A1 ist ein Verfahren bekannt zur Simulation der Planung eines Raums unter Verwendung von Zierelementen, insbesondere von Elementen, die aus einem Plattenmaterial geschnitten und/oder bearbeitet und/oder unter Verwendung dieser Platte oder Platten , insbesondere aus einem Material mit zufälligen oder besonderen Mustern, hergestellt werden, wobei dieses Verfahren den Schritt umfasst, einem Benutzer mit Hilfe eines Simulationswerkzeugs zu ermöglichen, eine Installationskonfiguration zu simulieren, bei der die Zierelemente maßstabsgetreu auf ein insbesondere digitales 2D- oder 3D-Modell des zu planenden Raums an einer gewünschten Position und mit einer gewünschten Ausrichtung projiziert werden, wobei die Zierelemente während dieser Simulation maßstabsgetreu mit dem Modell angezeigt werden, und zwar mit ihrem tatsächlichen Aussehen, wie es sich aus einer vorherigen digitalen Erfassung der Zierelemente oder des oder der Blätter durch ein Erfassungsmittel ergibt.

Ein Steinschneide- und Veredelungsverwaltungssystem zur Verwaltung eines Bestands an Steinplatten ist aus der US 2007/282718 A1 bekannt. Das in dieser Schrift offenbarte System dient zur Verwaltung eines Bestandes an natürlichen oder bearbeiteten Steinplatten zur Verwendung beim Schneiden und Formen einer ausgewählten Steinplatte in Teile wie Arbeitsplatten.

Auch aus der CN 109727281 A ist ein Verfahren zum virtuellen Schneiden von großen Steinplatten bekannt.

Vor diesem Hintergrund liegt der Erfindung die Aufgabe zugrunde, das Blending zu vereinfachen und die Herstellung von Tafeln aus größeren Platten insgesamt zu verbessern.

Soweit im Folgenden Varianten der Erfindung beschrieben werden, können diese beliebig miteinander kombiniert werden, sofern eine Kombination aus technischen Gründen nicht ausgeschlossen ist.

Zur Lösung der zuvor genannten Aufgabe schlägt die Erfindung die Merkmale von Anspruch 1 vor. Insbesondere wird somit erfindungsgemäß bei einem Verfahren zur Bestimmung von Zuschnittparametern für Platten zur Lösung der genannten Aufgabe vorgeschlagen, dass Abbildungen der Platten zusammen mit Größenmaßen derselben bereitgestellt werden, dass ein geometrisches Modell einer Vertäfelung einer Fläche bereitgestellt wird, das zumindest Position, Form und Größe von Tafeln der Vertäfelung umfasst, dass den Tafeln jeweils ein deckungsgleicher Ausschnitt einer der Abbildungen zugeordnet wird und dass die Zuschnittparameter durch geometrische Parameter der Ausschnitte gegeben sind.

Bevorzugt umfasst das Modell zumindest Position, Form und Größe sämtlicher die Vertäfelung bildenden Tafeln. Allerdings brauchen auch in diesem Fall für das erfindungsgemäße Verfahren nicht zwingend sämtliche Tafeln der Vertäfelung zu Ausschnitten der Abbildungen zugeordnet werden, da auch an teilweisen Zuordnungen Interesse bestehen kann.

Es kann insbesondere vorgesehen sein, dass die Abbildungen bereitgestellt werden, indem durch eine Messung ein Abbild der Platten erstellt wird. Hierzu können die Platten beispielsweise abfotografiert oder gescannt werden. Vorzugsweise wird das Abbild der Platten von oben erstellt. Gleichmäßige, gleiche und/oder gleichbleibende Belichtungsbedingungen sind von Vorteil. Ein geeignetes Mittel für die Messung kann ein Messgerät mit einem Sensor sein, wie etwa eine Kamera oder ein Scanner.

Die Abbildungen können auch als Bilddateien bereitgestellt werden. Bevorzugt ist vorgesehen, dass die Abbildungen in einer elektronischen Datenbank abgelegt sind oder dass diese nach Bereitstellung zu einer solchen hinzugefügt werden.

Die Größenmaße können beispielsweise eine Länge und/oder eine Breite der jeweiligen Platte umfassen. Bevorzugt werden die Größenmaße und ggf. weitere geometrische Parameter der Platten bereitgestellt, indem diese gemessen werden oder aus Messungen abgeleitet werden. Die Größenmaße können auch bereitgestellt werden, indem die Abbildungen mit den betreffenden Größenmaßen verknüpft sind. Eine solche Verknüpfung kann beispielsweise durch eine Datenstruktur gegeben sein oder in einer Datenbank abrufbar abgelegt sein.

Das geometrische Modell der Vertäfelung kann beispielsweise in Form eines elektronisch erfassten Architekturplans bereitgestellt werden.

Die Position der Tafeln kann durch eine Ortskoordinate auf der Fläche gegeben sein. Die Größe der Tafeln kann durch einen Referenzmaßstab ermittelbar sein oder auch explizit in Form beispielsweise einer Länge und/oder einer Breite vorgegeben sein. Die Form der Tafeln kann durch eine Grundform und eine Orientierung der Grundform in Bezug auf die Fläche gegeben sein. Die Form kann auch schlicht durch die Umrandung der Tafel gegeben sein.

Ausschnitt und Tafel können insbesondere dann als deckungsgleich bezeichnet werden, wenn diese in Form und Größe gleich sind. Um eine solche Deckungsgleichheit herstellen zu können, können die breitgestellten Größenmaße der Abbildungen und die Form und Größe der Tafeln verwendet werden.

Ein Ausschnitt einer Abbildung ist insbesondere durch einen Bildausschnitt gegeben. Ein Ausschnitt einer Abbildung kann daher dadurch charakterisiert sein, dass er einen Teilbereich der Abbildung umfasst. Der Ausschnitt hat daher auch zumindest eine Umrandung, die im Grunde beliebig geformt sein kann. Häufig werden die Tafeln allerdings eine regelmäßige Geometrie aufweisen, sodass auch die Ausschnitte eine solche regelmäßige Geometrie haben. Beliebt ist beispielsweise eine Rechtseckform.

Die Zuschnittparameter sind bevorzugt solche, aus denen ein Zuschnitt der Platten ableitbar ist. Gleiches gilt daher für die geometrischen Parameter der Ausschnitte der Abbildungen. Um eine Platte zuschneiden zu können, müssen die Schneidlinien bestimmbar sein. Hierzu genügt beispielsweise eine Kenntnis der Umrandung der Ausschnitte auf den Abbildungen oder die Form und Größe der Ausschnitte zusammen mit deren Position auf der jeweils zugehörigen Platte.

Die Platten sind bevorzugt Steinplatten. Allerdings können die Platten aus einem beliebigen anderen Material gefertigt sein wie etwa aus Holz, Porzellan oder Glas.

Durch die Erfindung wird eine Digitalisierung des Blendings ermöglicht. Das Blending wird durch die Erfindung signifikant vereinfacht und kann nicht nur von Architekten und anderen Experten, sondern auch von Privatpersonen durchgeführt werden. Ferner kann das Blendingergebnis verbessert werden, da die Digitalisierung ermöglicht, die Platten erst nach dem Blending zuzuschneiden, so dass die geschnittenen Tafeln noch besser als zuvor aufeinander abgestimmt werden können. Außerdem ermöglicht die Digitalisierung den Einsatz automatischer Verfahren, sodass die Kosten für das Blending noch weiter reduziert werden können. Ferner wird ein direkter Vertriebsweg zwischen dem Steinhersteller und dem Endkunden ermöglicht, sodass kostentreibende Zwischenhandelsstufen nicht zwingend erforderlich sind.

Erfindungsgemäß ist vorgesehen, dass die Tafeln jeweils eine eindeutige Kennung erhalten. Diese wird bevorzugt mit den Zuschnittparametern des zugeordneten Ausschnitts der Abbildungen verknüpft. Hierdurch ist erreichbar, dass nach einem durchgeführten Zuschnitt die zugeschnittenen Tafeln beim Verlegen in die Anordnung gebracht werden können, die der Anordnung entsprechen, die bei der Durchführung des erfindungsgemäßen Verfahrens gefunden wurde.

Alternativ oder zusätzlich kann vorgesehen sein, die Abbildungen der Platten eine eindeutige Kennung erhalten, die jeweils mit den Zuschnittparametern desjenigen Ausschnitts verknüpft werden, welcher der Abbildung angehört, die die Kennung erhalten hat. Dies erlaubt es, die jeweils zuzuschneidende Platte auf einfache Weise zuzuordnen. So bietet es sich an, auch die Platten mit der Kennung ihr jeweiligen Abbildung oder zumindest mit einer dieser eineindeutig zuordenbaren Kennung zu versehen.

Beispielsweise kann das Verfahren einen Vektor aus 3-Tupeln erzeugen, deren erster Eintrag die Kennung der Tafel ist, deren zweiter Eintrag die Kennung der zugeordneten Abbildung und somit auch der zugeordneten Platte ist und deren dritter Eintrag die Zuschnittparameter zu dem zugeordneten Ausschnitt dieser Platte ist. Diese Daten können einen Zuschnitt der Platten hinreichend spezifizieren, sodass mit diesen die Platten zugeschnitten werden können.

Es kann vorgesehen sein, dass zumindest die Zuschnittparameter zur späteren Verwendung in einem Datenspeicher abgespeichert werden. Ferner kann vorgesehen sein, dass eine Datenstruktur erstellt wird, die die Zuschnittparameter, vorzugsweise auch Kennungen der Tafeln und der Abbildungen der Platten, umfasst, und die Datenstruktur während und/oder nach Durchlaufen der zuvor beschriebenen Verfahrensschritte in einem Datenspeicher abgelegt wird.

Alternativ oder zusätzlich kann vorgesehen sein, dass ein Projektzustand, der zumindest die Zuordnungen der Tafeln zu den Abbildungen umfasst, gespeichert wird. Bevorzugt erfolgt die Speicherung so, dass auf den Projektzustand von verschiedenen Standorten aus vorzugsweise gleichzeitig zugreifbar ist und/oder dass der Projektzustand gleichzeitig von den verschiedenen Standorten aus änderbar ist. Hierzu kann insbesondere vorgesehen sein, dass der Projektzustand in einem Datenspeicher eines Servers gespeichert wird, auf den mehrere Clients zugreifen können oder dass der Projektzustand in einem Datenspeicher gespeichert wird, auf den ein Server und mehrere Clients zugreifen können. Die Zuordnungen der Tafeln zu den Abbildungen können beispielsweise durch die zuvor beschriebene Datenstruktur gegeben sein. Der Projektzustand umfasst bevorzugt auch das geometrische Modell. Außerdem umfasst der Projektzustand bevorzugt Kennungen der Tafeln. Der Projektzustand umfasst ferner bevorzugt die zugeordneten Abbildungen oder Kennungen, die einen zuordenbaren Zugriff auf die zugeordneten Abbildungen erlauben. Durch derartige Ausgestaltungen wird insbesondere eine parallele Ausführung des Verfahrens durch mehrere Personen und eine parallele Bearbeitung eines Blending-Projekts ermöglicht.

Um eine Zuordnung manuell vornehmen zu können oder um ein Zuordnungsergebnis leicht überprüfen zu können, kann bei einer weiteren Ausgestaltung des Verfahrens vorgesehen sein, dass die Abbildungen angezeigt werden und/oder zumindest Form und Position der Tafeln angezeigt werden. Die Tafeln können zunächst ohne Texturen angezeigt werden. Nach einer Zuordnung zu Ausschnitten der Plattenabbildungen, können die Tafeln auch mit Texturen angezeigt werden, die von den jeweils zugeordneten Ausschnitten gebildet sind. Es versteht sich, dass nicht alle Abbildungen zu jeder Zeit angezeigt sein müssen. Üblicherweise werden auf einer aktuellen Anzeige wie etwa einem Bildschirm nur eine begrenzte Anzahl von ausgewählten Abbildungen angezeigt, während die übrigen Abbildungen ausgeblendet oder vollständig oder teilweise verdeckt werden.

Um das aktuelle Blending einsehen zu können und leicht anpassen zu können, kann vorgesehen sein, dass die den jeweiligen Tafeln zugeordneten Ausschnitte der Abbildungen als Texturen auf der jeweils zugeordneten Tafel angezeigt werden.

Alternativ oder zusätzlich kann vorgesehen sein, dass die Abbildung mittels Drag-And-Drop der Tafel zugeordnet wird. Hierzu kann die Abbildung beispielsweise mit einer Computermaus oder bei einem Touch-Screen mit dem Finger angeklickt werden und zu der Tafel bewegt werden, wo die Abbildung dann abgelegt wird. Dies stellt eine besonders ergonomische Interaktion dar, die das Blending weiter vereinfacht.

Bei einer weiteren vorteilhaften Ausgestaltung des Verfahrens kann vorgesehen sein, dass Begrenzungen von zugeordneten Ausschnitten auf deren Abbildung angezeigt werden. Bevorzugt erfolgt dies durch Anzeigen einer die jeweilige Begrenzung beschreibende Linie. Dies ermöglicht dem Anwender unmittelbar zu erkennen, welcher Ausschnitt einer Platte einer bestimmten Tafel zugeordnet ist, sodass er einerseits erkennen kann, ob ein verschobener und/oder rotierter Ausschnitt das Blendingergebnis verbessern könnte und andererseits direkt erkennt, welche Bereiche der Platte noch für weitere Tafeln zur Verfügung stehen. Ein Synergieeffekt wird insbesondere erzielt, wenn zugleich auch der Ausschnitt auf der zugeordneten Tafel angezeigt wird.

Bei einer weiteren Ausgestaltung des Verfahrens mit möglicherweise besonders hervorgehobener erfinderischer Qualität kann vorgesehen sein, dass durch eine Interaktion mit einer der angezeigten Tafeln der auf der Tafel angezeigte Ausschnitt der Abbildung verschoben und/oder rotiert wird. Vorzugsweise wird der Ausschnitt als Textur auf der Tafel angezeigt. Der Ausschnitt wird daher in der Abbildung, der er angehört oder der er entnommen ist, verschoben und/oder rotiert. Entsprechend wird ein verschobener und/oder rotierter Ausschnitt der Abbildung auf der Tafel angezeigt. Weiter wird die Interaktion bevorzugt mit einem Eingabemittel wie etwa einer Computermaus, einem Berührungssensor oder einem Sprachbefehl ausgelöst. Die Besonderheit dieser Ausgestaltung liegt darin begründet, dass zur Verschiebung des Ausschnitts nicht die Abbildung aufgerufen werden muss, sondern dass der Ausschnitt unmittelbar durch eine Interaktion mit der Tafel verschoben bzw. rotiert werden kann. Dies ist besonders vorteilhaft, da es um das Blending der Vertäfelung geht und somit der Anwender seine Wahrnehmung auf diese richten möchte und nicht auf die Abbildungen. Die Abbildung braucht für diesen Vorgang nicht einmal eingeblendet zu sein.

Es kann vorgesehen sein, dass mehr als eine Zuordnung von Tafeln und Ausschnitten computergestützt vorgenommen und angezeigt wird und dass aus den mehreren Zuordnungen eine ausgewählt wird. Dies ermöglicht dem Anwender, aus mehreren Blendings ein für ihn am geeignetsten erscheinendes auszuwählen.

Bei einer weiteren Ausgestaltung des Verfahrens kann vorgesehen sein, dass Zuordnungen von zumindest manchen oder von allen Tafeln zu Ausschnitten der Abbildungen rein computergestützt erfolgen. Bevorzugt werden hierzu Optimierungsverfahren und/oder Verfahren der künstlichen Intelligenz verwendet. Weiter werden bevorzugt für die computergestützte Zuordnung Zielkriterien vorgegeben. Ein Zielkriterium kann beispielsweise darin bestehen, dass ein Versatz von Maserungen zwischen benachbarten Tafeln möglichst vermieden wird. Dies kann mathematisch beispielsweise durch eine Bestrafungsfunktion ausgedrückt werden, die einen umso größeren Wert annimmt, je größer ein Versatz ist. Die Maserungen können beispielsweise durch Bildregistrierungsverfahren ermittelt werden. Bei derartigen Ausgestaltungen sucht das computergestützte Verfahren daher nach geeigneten Ausschnitten in den Abbildungen und ordnet diese den Tafeln zu.

Nützlich kann ein solches Verfahren nicht nur sein, um geeignete Blendingvorschläge für die gesamte Vertäfelung zu erhalten, sondern beispielsweise auch dann, wenn bei einem Transport eine Platte oder eine Tafel zerstört wird und durch eine möglichst ähnliche ersetzt werden soll. Als Zielkriterium kann in einem solchen Fall beispielsweise eine möglichst geringe Abweichung des neu auszuwählenden Ausschnitts zu dem vorherigen Ausschnitt gewählt werden. Dies kann beispielsweise durch eine Abstandnorm ausgedrückt werden, die die farblichen Abweichungen jedes einzelnen Pixels gewichtet und aufsummiert. Für den Menschen wäre es sehr aufwändig, jede einzelne verfügbare Abbildung zu durchforsten, um einen ähnlichen Ausschnitt zu finden. Dies kann ein Computer deutlich schneller und effektiver. Ist ein geeigneter Ausschnitt gefunden, kann dieser sodann aus der ersetzenden Platte geschnitten werden und nachgesendet werden.

Es kann ferner vorgesehen sein, dass eine manuelle und eine rein computergestützte Zuordnung alternierend abwechseln, bis für alle Tafeln Zuordnungen gefunden sind. Ein solches iteratives Vorgehen kann vorteilhaft sein, da dann Zwischenergebnisse des Blendings leichter überprüft und angepasst werden können. Mit manueller Zuordnung ist gemeint, dass eine menschliche Interaktion mit angezeigten Objekten erfolgt. Dies braucht nicht zwingend mit der Hand erfolgen, sondern kann auch auf andere Weise wie beispielsweise durch eine Sprachanweisung erfolgen. Ferner finden auch bei manueller Zuordnung computergestützte Vorgänge statt, um die Zuordnung in weiterverarbeitbarer Form zu bewirken.

Um physikalisch nicht umsetzbare Zuordnungen zu vermeiden, kann vorgesehen sein, dass bei einer Zuordnung einer der Tafeln zu einem der Ausschnitte und/oder bei einer Änderung des Ausschnitts geprüft wird, ob der Ausschnitt oder ein Teil hiervon bereits einer anderen Tafel zugeordnet und/oder außerhalb der zugeordneten Platte liegt. Bevorzugt wird eine Aktion ausgelöst, wenn dies positiv festgestellt wird. Vorzugsweise unterbleibt die Zuordnung und/oder Änderung des Ausschnitts und/oder es wird ein optisches Signal erzeugt.

Bei einer weiteren vorteilhaften Ausgestaltung des Verfahrens kann vorgesehen sein, dass während oder nach Zuordnung der Tafeln zu Ausschnitten der Abbildungen computergestützte Zuordnungsanfragen von Tafeln, die nicht der Vertäfelung angehören, zu zuordnungsfreien Bereichen der Abbildungen bearbeitet, insbesondere geprüft und/oder akzeptiert, werden. Bevorzugt erfolgt dies erst nach vollständiger Zuordnung der Tafeln zu den Ausschnitten der Abbildungen. Derartige Ausgestaltungen haben den Vorteil, dass Reste von Platten, die andernfalls weggeschmissen würden, einer weiteren Verwertung zugeführt werden können. Hierdurch wird der Ertrag des Herstellers der Platten erhöht und die Natur geschont.

Bei einer weiteren vorteilhaften Ausgestaltung des Verfahrens kann vorgesehen sein, dass eine texturfreie Gestaltung der Vertäfelung der Fläche bereitgestellt und angezeigt wird und dass die texturfreie Gestaltung der Vertäfelung in eine Texturen umfassende Gestaltung überführt wird, indem Ausschnitte der Abbildungen bestimmt werden und als Texturen für die Tafeln verwendet werden.

Es hat sich gezeigt, dass das Blendingergebnis erheblich verbessert werden kann, indem Ausschnitte der Abbildungen der Platten nicht direkt mit dem bereitgestellten Modell verknüpft werden, sondern indem in einem ersten Schritt eine Objekterkennung der Tafeln durchgeführt und entsprechend dem Planungsstand fortlaufend aktualisiert wird. In einem weiteren Schritt erfolgt eine Verknüpfung der Ausschnitte mit den erkannten Objekten. Hierdurch kann das Blending erheblich flexibler durchgeführt werden. Dies ermöglicht es, unterschiedliche, disjunkte oder sich überlappende Teilbereiche der zu vertäfelnden Fläche zu blenden und das Zwischenresultat in das Gesamtmodell zu übernehmen. Auch können so sich ändernde Parameter der bereitgestellten Modelle erkannt und aktualisiert übergeben werden. Ferner ermöglicht dies auf einfache Weise, mehrere Blendingvarianten aus gleichen Platten zeitgleich und ortsunabhängig zu erzeugen. Ein Projekt kann so parallel durch mehrere ortsunabhängige Personen geblendet und optimiert werden. Auch außerhalb des Projekts liegende Anfragen können auf diese Weise effektiv integriert werden. Einige vorteilhafte Verfahrensvarianten werden im Folgenden genauer beschrieben.

Bei einer weiteren vorteilhaften Ausgestaltung des Verfahrens kann vorgesehen sein, dass die Bereitstellung des Modells eine Bereitstellung von Teilmodellen des Modells umfasst oder durch eine Bereitstellung von Teilmodellen erfolgt. Die Teilmodelle können unveränderlich oder auch veränderlich sein. Die Teilmodelle können disjunkt sein. Beispielsweise kann das geometrische Modell bereitgestellt werden, indem ein Architekturplan einer Wand und ein weiterer Architekturplan einer angrenzenden Decke bereitgestellt wird. Die Teilmodelle können auch einen Überlappungsbereich haben. Beispielsweise kann es einen 3D-Plan und zusätzliche, vorzugsweise detailorientierte, 2D-Pläne geben. Ferner kann ein Gesamtplan in mehrere, sich überlappende Teilpläne aufgeteilt sein. Dies kann insbesondere bei größeren Flächen, beispielsweise oberhalb von 200 m² oder oberhalb von 400 m², von Vorteil sein. Mehrere Teilmodelle können für den Verwender übersichtlicher sein als die Verwendung eines einzigen Modells und stellen die Grundlage für einen kontinuierlichen Produktionsprozess dar.

Es kann vorgesehen sein, dass sich das Modell und/oder die Teilmodelle während des Verfahrens ändern können und dass die Zuordnungen von Ausschnitten zu Tafeln bei einer Änderung automatisch aktualisiert werden.

Bei einer weiteren vorteilhaften Ausgestaltung des Verfahrens kann vorgesehen sein, dass in dem Modell die Tafeln identifiziert und jeweils mit ihrer eindeutigen Kennung versehen werden. Die Identifizierung der Tafeln erfolgt bevorzugt computergestützt, besonders bevorzugt vollautomatisch. Das bereitgestellte Modell kann beispielsweise durch mehrere Architekturpläne bereitgestellt werden. Liegen diese in elektronischer Form, wie etwa in einem .dxf-Format, vor, so kann es von Vorteil sein, dass zunächst mittels eines geeigneten Verfahrens die Tafeln als Objekte erkannt und isoliert und somit identifiziert werden. Um geeignete Verfahren zu entwickeln, kann der Fachmann insbesondere auf Kenntnisse aufbauen, die ihm aus der Computergrafik bekannt sind. Wird das Modell beispielsweise in Form von Linien bereitgestellt und handelt es sich bei den Flächen um polygonale Flächen, so können Tafeln identifiziert werden, indem nach Linien gesucht wird, die einen geschlossenen Polygonzug bilden. Auch runde Linien können einbezogen werden. Häufig enthalten Architekturpläne zusätzliche Informationen wie etwa Maßangaben und Bearbeitungsdetails. Die Bearbeitungsdetails können beispielsweise Angaben über zu fräsende oder abzurundende Kanten, Hinterschnittanker, Schrägschnitte oder dergleichen enthalten. Diese können ebenfalls eingelesen und für die Identifizierung der Tafeln und deren benötigte Grunddaten wie etwa Position, Form, Orientierung und/oder Größe verwendet werden.

Bevorzugt erfolgt die Identifizierung und Kennzeichnung der Tafeln vollautomatisch. Hierzu kann auch der Einsatz einer künstlichen Intelligenz vorteilhaft sein, da die in den bereitgestellten Modellen zur Verfügung gestellten Informationen nicht zwingend an eine einheitliche Darstellung halten müssen und daher durch eine künstliche Intelligenz einer Fehleranfälligkeit reduziert werden kann. Beispielsweise können Methoden des maschinellen Lernens zur Anwendung kommen.

Es kann ferner vorgesehen sein, dass bei der Identifizierung computergestützt mögliche Inkonsistenzen in Teilmodellen erkannt und bevorzugt sodann auch computergestützt optisch angezeigt und/oder behoben werden.

Bei einer weiteren vorteilhaften Ausgestaltung von besonderer Relevanz kann vorgesehen sein, dass aus dem Modell ein Teilmodell erzeugt wird. Bevorzugt umfasst das Teilmodell mindestens eine Kennung einer Tafel, welche auch einem anderen Teilmodell zugeordnet ist. Die Erzeugung solcher Teilmodelle kann dem Blending einen entscheidenden Vorteil bringen. Der Nutzer kann sich auf diese Weise auf einen Bereich konzentrieren, den er gestalten und/oder vorrangig produzieren möchte. Diesen Bereich kann der Nutzer definieren und das entsprechende Teilmodell erzeugen lassen. Durch die Überlappung mit anderen Teilmodellen kann der Nutzer sicherstellen, dass sich der geblendete Teilbereich auch harmonisch an seine angrenzenden Bereiche anschließt. Damit ist ein Produktionsstart von Teilbereichen ohne vollständiges Blending des Gesamtmodells möglich. Für die Produktion freigegebene Bereiche werden durch die Kennung vorzugsweise in einem Überlappungsbereich von angrenzenden Teilmodellen automatisch fixiert, sodass die Zuordnung der überlappenden Tafeln zu den jeweiligen Ausschnitten der Abbildungen bereits festgelegt ist und vorzugsweise nicht mehr änderbar ist.

Zur Verbesserung der Nutzerfreundlichkeit und damit des potentiellen Arbeitsergebnisses kann bei einer weiteren vorteilhaften Ausgestaltung des Verfahrens vorgesehen sein, dass zumindest Form und Position mindestens einer der Tafeln mindestens zweifach angezeigt wird. Bevorzugt ist die Tafel Bestandteil unterschiedlicher Teilmodelle und/oder Darstellungen.

Zur weiteren Verbesserung der Blendings kann vorgesehen sein, dass der einer Tafel zugeordnete Ausschnitt einer der Abbildungen als Textur auf jeder der angezeigten Tafeln dargestellt wird. Eine Interaktion ist mit jeder der angezeigten Tafeln, die eine gleiche Kennung haben, möglich. Bevorzugt ist vorgesehen, dass sich der Ausschnitt bei jeder der angezeigten Tafeln gemäß der Interaktion mit einer der angezeigten Tafeln verschiebt. Parallel können zu jeder Kennung eindeutige Produktionsdaten für die jeweils zugeordnete Tafel computergestützt ermittelt und für die Herstellung der jeweilige Tafel zusammengefasst werden, also insbesondere die geometrische Parameter wie etwa die Maßangaben und/oder die Bearbeitungsdetails.

Bei einer weiteren vorteilhaften Ausgestaltung des erfindungsgemäßen Verfahrens kann vorgesehen sein, dass erste Zuschnittparameter zunächst für das erste Teilmodell bestimmt und zur Herstellung der Tafeln freigegeben werden und dass sodann zweite Zuschnittparameter für das zweite Teilmodell bestimmt werden, wobei das zweite Teilmodell eine Kennung einer gemeinsamen Tafel umfasst, welche auch dem ersten Teilmodell zugeordnet ist, wobei der der gemeinsamen Tafel zugeordnete Ausschnitt einer der Abbildungen bei der Bestimmung der zweiten Zuschnittparameter durch die Freigabe der ersten Zuschnittparameter zur Herstellung der Tafeln unveränderbar festgelegt wird. Das erste und das zweite Teilmodell sind hierbei Teilmodelle des zuvor erwähnten geometrischen Modells. Eine solche Weiterbildung des Verfahrens hat den Vorteil, dass zunächst eine erste Teilfläche geblendet und die benötigten Tafeln hergestellt werden können und dass im Anschluss hieran durch die Übergabe bereits geblendeter Bereiche an eine zweite Teilfläche ein harmonisch auf die erste Teilfläche abgestimmtes Blending der zweiten Teilfläche ermöglicht wird. Hierdurch kann bereits mit der Produktion begonnen werden, bevor das gesamte Projekt vollständig geblendet worden ist. Für die Herstellung der Tafeln des zweiten Teilmodells werden die Zuschnittsparameter von solchen Tafeln nicht benötigt, die bereits dem ersten Teilmodell zugeordnet sind. Bevorzugt enthalten die für die Herstellung freigegebenen zweiten Zuschnittsparameter daher Zuschnittsparameter nur für solche Tafeln, welche nicht auch dem ersten Teilmodell zugeordnet sind.

Zur Lösung der zuvor genannten Aufgabe schlägt die Erfindung ferner die Merkmale des auf ein zur Herstellung von Tafeln für eine Vertäfelung einer Fläche gerichteten nebengeordneten Anspruchs vor. Insbesondere wird somit erfindungsgemäß bei einem solchen Verfahren zur Lösung der genannten Aufgabe vorgeschlagen, dass die Tafeln aus Platten geschnitten werden, dass Zuschnittparameter für die Platten mittels eines Verfahrens, das erfindungsgemäß, insbesondere wie zuvor beschrieben oder nach einem auf ein Verfahren zur Bestimmung von Zuschnittparametern für Platten gerichteten Schutzansprüche, ausgebildet ist, bestimmt werden und wobei die Tafeln sodann anhand der Zuschnittparameter aus den Platten geschnitten werden. Die Vorteile, die ein solches Verfahren mit sich bringt, können dem bereits zuvor Beschriebenen entsprechend entnommen werden.

Bevorzugt ist vorgesehen, dass die bereits zuvor erwähnten Kennungen, welche die jeweiligen Tafeln bei der Ausführung eines wie zuvor oder weiter unten beschriebenen oder beanspruchten Verfahrens zur Bestimmung von Zuschnittparametern erhalten haben, auf die geschnittenen Tafeln aufgebracht werden. Dies kann durch Eingravieren auf der Rückseite einer Tafel erfolgen oder durch Auftragen eines Aufklebers oder dergleichen, aus dem die Kennung mit dem menschlichen Auge oder mittels eines elektronischen Lesegeräts gelesen werden kann. Die Kennung kann beispielsweise aus einer Zeichenkette bestehen oder aus einem sonstigen Code. Die Kennung kann wie beispielsweise bei einem QR-Code auch in eine andere Darstellung umgewandelt worden sein.

Sämtliche der zuvor genannten Verfahrensschritte können computergestützt, insbesondere vollautomatisch, erfolgen.

Die Erfindung wird nun anhand einiger weniger Ausführungsbeispiele näher beschrieben, ist jedoch nicht auf diese wenigen Ausführungsbeispiele beschränkt. Weitere Ausführungsbeispiele ergeben sich durch die Kombination der Merkmale einzelner oder mehrerer Schutzansprüche untereinander und/oder mit einzelnen oder mehreren Merkmalen der Ausführungsbeispiele.

Es zeigt:
- Fig. 1: ein Flussdiagramm eines Ausführungsbeispiels eines erfindungsgemäßen Verfahrens zur Herstellung von Tafeln für eine Vertäfelung einer Fläche,
- Fig. 2: ein Flussdiagramm eines Ausführungsbeispiels eines
- Fig. 3: Verfahrens zur Bestimmung von Zuschnittparametern für Platten, eine Illustration von gegenständlichen Komponenten, die bei der Ausführung der in Fig. 1 und Fig. 2 dargestellten Verfahren verwendet werden,
- Fig. 4: eine graphische Anzeige zu drei aufeinanderfolgenden Verfahrenszuständen mit dargestellten Interaktionen und Zuordnungen,
- Fig. 5: eine graphische Anzeige mit einer Darstellung von Mehrfachzuordnungen zu sich überlappenden Teilflächen.

Bei der nachfolgenden Beschreibung der Erfindung erhalten in ihrer Funktion übereinstimmende Elemente auch bei abweichender Gestaltung oder Formgebung übereinstimmende Bezugszahlen.

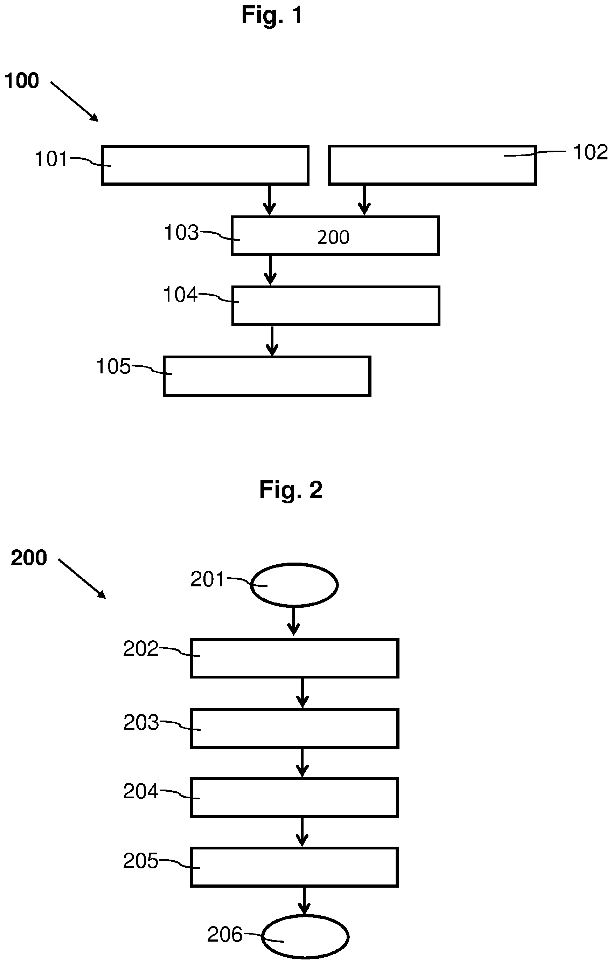

Fig. 1 zeigt ein Ausführungsbeispiel eines erfindungsgemäßen Verfahrens 100 zur Herstellung von Tafeln 2 für eine Vertäfelung 3 einer Fläche 1, wobei anschließend die Fläche 1 vertäfelt wird.

In Schritt 101 werden zunächst Platten 4 wie beispielsweise Steinplatten aus einem Steinbruch vorzugsweise von oben und mittels einer Kamera 5 fotografiert oder mittels eines Scanners gescannt und Abbildungen 13 der Platten 4 erstellt. Die Abbildungen 13 werden in einer Datei gespeichert. Bei der Bildaufnahme wird auf eine gleichmäßige und gleichbleibende Belichtung geachtet. Die Platten 4 werden vermessen und die Maße wie insbesondere die Flächenmaße der abgebildeten Oberfläche mit der jeweiligen Platte 4 verknüpft.

Weitere Abbildungen 13 und Maße von weiteren Platten 4, insbesondere von Steinplatten, können an anderen Orten mit einer entsprechenden Vorrichtung erstellt werden.

In Schritt 102 wird ein Plan, bei dem es sich um einen Architekturplan handeln kann, erstellt, der eine zu vertäfelnde Fläche 1 modelliert. Der Plan umfasst zumindest Position, Orientierung, Form und Maße von zu vertäfelnden Tafeln 2.

In Schritt 103 werden aus den Abbildungen 13 und dem Plan die zu verlegenden Tafeln 2 und deren Anordnung bestimmt, die sodann die Vertäfelung 3 bilden sollen. Hierzu wird das weiter unten beschriebene Verfahren 200 verwendet.

In Schritt 104 werden die zuvor bestimmten Tafeln 2 aus den Platten 4 geschnitten.

Die geschnittenen Tafeln 2 werden gemäß der zuvor bestimmten Anordnung gekennzeichnet und an den Ort der Fläche 1 gebracht.

In Schritt 105 werden die Tafeln 2 sodann gemäß der zuvor bestimmten Anordnung verlegt, sodass die Fläche 1 vertäfelt wird.

Fig. 2 zeigt ein Ausführungsbeispiel eines erfindungsgemäßen Verfahrens 200 zur Bestimmung von Zuschnittparametern für Platten 4.

In Schritt 201 werden zunächst Abbildungen 13 von Platten 4 und Plattenmaße, insbesondere deren Größenmaße wie Länge und Breite bereitgestellt.

Außerdem wird in Schritt 201 ein Plan bereitgestellt, der Position, Orientierung, Form und Größenmaße wie Länge und Breite der zu vertäfelnden Tafeln 2 umfasst. Jede Tafel 2 des Plans erhält eine eindeutige Kennung.

Die Abbildungen 13 der Platten 4 sind in einer Datenbank bereitgestellt oder werden sodann in eine Datenbank geladen. Jede Abbildung 13 erhält eine eindeutige Kennung.

In Schritt 202 werden eine oder mehrere Abbildungen 13 aus der Datenbank ausgewählt.

In Schritt 203 werden die ausgewählten Abbildungen 13 auf einer ersten Bildschirmfläche angezeigt. Außerdem wird auf einer zweiten Bildschirmfläche die zu modellierende Fläche 1 oder eine Teilfläche hiervon angezeigt, indem zumindest die Umrandungen der zu vertäfelnden Tafeln 2 angezeigt werden. Die erste und die zweite Bildschirmfläche können Flächen eines gleichen Bildschirms 8 bilden oder Flächen vollständig oder teilweise unterschiedlicher Bildschirme 8.

In Schritt 204 kann der Anwender beispielsweise mittels Drag-and-Drop Ausschnitte 19 der angezeigten Abbildungen 13 der Platten 4 auf den angezeigten Tafelflächen, also den Flächen, die die angezeigten Umrandungen der Flächen umschließen, anzeigen lassen. Bei Drap-And-Drop klickt der Anwender hierzu einfach auf eine der angezeigten Abbildungen 13 und verschiebt die Abbildung 13 beispielsweise mit einer Computermaus an den Ort einer, vorzugsweise bereits zuvor ausgewählten Tafel 2. Anhand der Größeninformationen von Platte 4 und Tafel 2 wird sichergestellt, dass der auf der Tafelfläche angezeigte Ausschnitt 19 der Platte 4 den Größenverhältnissen der Tafel 2 auch tatsächlich entspricht.

In Schritt 205 kann der Anwender den auf der Tafelfläche angezeigten Ausschnitt 19 der Platte 4 anpassen, indem er durch eine Interaktion mit der angezeigten Tafel 2 den Ausschnitt 19 verschiebt oder rotiert. Mit Verschieben ist hierbei gemeint, dass sich der Ausschnitt 19 in der Abbildung 13 verschiebt. Die Tafel 2 wird nicht verschoben. Allerdings ändert sich der auf der Tafel 2 angezeigte Ausschnitt 19 gemäß der Verschiebung und/oder Rotation des Ausschnitts 19 in der Abbildung. Auch für diese Interkationen werden bevorzugt Funktionen der Computermaus genutzt wie beispielsweise Bewegungen der Maus und das Anklicken, Halten und/oder Loslassen von Tasten der Computermaus.

Es ist hierzu nicht erforderlich, dass die Abbildung 13 der Platte 4 noch angezeigt wird. Wird sie allerdings noch angezeigt, so wird in dem hier beschriebenen Ausführungsbeispiel eine Umrandung der Tafel 2 mit übereinstimmendem Größenverhältnis auch auf der Abbildung der Platte 4 angezeigt. Wird sodann der auf der Tafel 2 angezeigte Ausschnitt der Platte angepasst, so verschiebt oder dreht sich die auf der Platte 4 angezeigte Umrandung entsprechend. Der Anwender kann daher unmittelbar sehen, welchen Ausschnitt 19 der Platte 4 er gerade für die Tafel 2 vorsieht und welche Ausschnitte 19 noch zur Verfügung stehen.

Wird eine Abbildung 13 einer Platte 4 für mehrere Tafeln 2 verwendet, so werden alle bereits zugeordneten Ausschnitte 19 auf der Abbildung 13 der Platte 4 angezeigt.

Es kann hierbei zu Doppelzuordnungen kommen oder dazu, dass ein Teil der Tafel 2 außerhalb der Platte 4 liegt. Es kann daher vorgesehen sein, dass physikalisch nicht umsetzbare Zuordnungen nicht zugelassen werden. Beispielsweise kann vorgesehen sein, dass ein Ausschnitt 19 einer Abbildung 13 nicht weiter verschoben werden kann, wenn eine Außenbegrenzung der Platte 4 und/oder ein Bereich einer Platte 4 erreicht wird, der bereits einer anderen Tafel 2 zugeordnet ist.

Alternativ kann vorgesehen sein, dass derartige nicht real umsetzbare Zuordnungen zunächst zugelassen werden, dann aber in einem Überprüfungsschritt beanstandet werden.

Im Wege der zuvor beschriebenen Interaktionen kann der Anwender sukzessive allen Tafeln 2 ein ihm geeignet erscheinenden Ausschnitt 19 einer Platte 4 zuordnen und so das Blending vollenden.

Alternativ oder zusätzlich zu dieser manuell erfolgten Zuordnung kann eine solche Zuordnung bei manchen Tafeln 2 oder sogar bei allen Tafeln 2 auch rein computergestützt erfolgen. Wie dies erfolgen kann, ist bereits zuvor genauer beschrieben worden.

In Schritt 206 wird sodann das Blending-Ergebnis, bei dem sich auch um ein Zwischenergebnis handeln kann, in einer geeigneten Datenstruktur zusammengefasst und die Datenstruktur wird abgespeichert, bevorzugt in einem Datenspeicher eines Servers, so dass mehrere Personen von verschiedenen Standorten auf das Blending-Ergebnis zugreifen können. Um später zu wissen, welche Platte 4 welcher Tafel 2 zugordnet ist, kann die Datenstruktur beispielsweise einen Vektor von Tupeln enthalten, dessen erster Eintrag die Kennung der Tafel 2 und dessen zweiter Eintrag die Kennung der zugeordneten Platte 4 ist. Ein dritter Eintrag kann die Informationen umfassen, welche den der jeweiligen Tafel 2 zugeordneten Ausschnitten 19 auf der Platte 4 entsprechen, also insbesondere die Zuschnittparameter, die für einen späteren Zuschnitt der Tafeln 2 aus den Platten 4 benötigt werden. Bei rechteckigen Tafeln 2 genügt hierzu die Angabe der Orte der vier Ecken, bei komplizierteren Geometrien werden weitere Informationen benötigt.

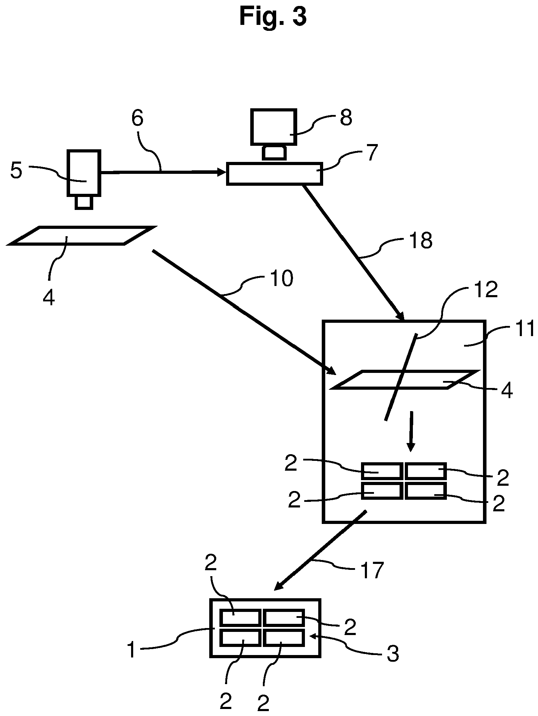

Das zuvor beschriebene Verfahren zur Herstellung von Tafeln 2 für eine Vertäfelung 3 einer Fläche 1 und hierfür verwendbare Mittel sind in Fig. 3 dargestellt.

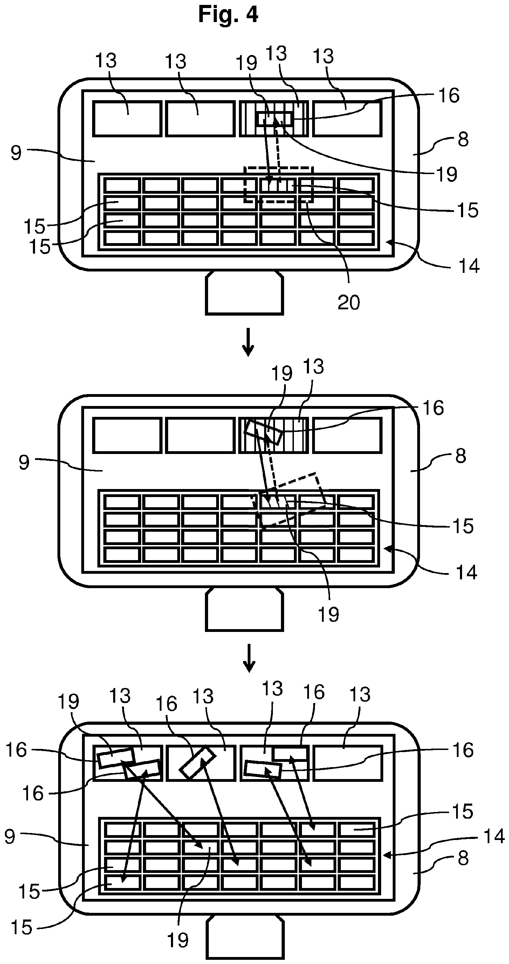

Zunächst werden mittels einer Kamera 5 Aufnahmen von Oberflächen der Platten 4 erstellt. Die erzeugten Abbildungen 13 werden als Bilddateien über eine Datenleitung 6, bei der es sich beispielsweise um eine drahtgebundene Leitung oder um eine drahtlose Leitung wie etwa eine Internetverbindung handeln kann, auf einen Computer 7 übertragen. Der Computer 7 hat einen Bildschirm 8, auf dem die Abbildungen 13 und das Modell 14 der Vertäfelung 3 angezeigt werden wie zuvor beschrieben und teilweise auch in Figur. 4 gezeigt. Mittels des Computers 7 und dessen Bildschirms 8 kann insbesondere das zuvor beschriebene Verfahren zur Bestimmung von Zuschnittparametern für Platten 3 ausgeführt werden.

Über eine weitere Datenleitung 18, vorzugsweise über eine Internetleitung, werden die ermittelten Zuschnittsparameter und zugeordnete Kennungen der Tafeln 2 und Platten 4 auf eine Schneidmaschine 11 übertragen, die eingerichtet ist, aus den übermittelten Daten einen Zuschnitt der über den Transportweg 10 gelieferten Platte 4 vorzunehmen. Hierzu hat die Schneidmaschine 11 nicht näher dargestellte Sensoren und Justiermittel zur relativen Platzierung von Schneidwerkzeug 12 und Platte 4.

Die zugeschnittenen Tafeln 2 werden sodann über den weiteren Transportweg 17 zum Ort der zu vertäfelnden Fläche 1 gebracht. Dort werden die Tafeln 2 verlegt und die Vertäfelung 3 hergestellt.

Fig. 4 zeigt eine graphische Anzeige 9 zu drei aufeinanderfolgenden Verfahrenszuständen mit dargestellten Interaktionen mit graphisch dargestellten Elementen 13, 15 und Zuordnungen von Tafeln 2 zu Abbildungen 13 von Platten 4.

Zu dem in Fig. 4 oben dargestellten Verfahrenszustand sind auf der Anzeige 9 des Bildschirms 8 im oberen Bereich Abbildungen 13 der Platten 4 angezeigt. Diese Abbildungen 13 sind zuvor bereits von dem Anwender ausgewählt worden. Im unteren Bereich ist ein Modell 14 der Vertäfelung 3 angezeigt, bei dem insbesondere die Form und Position der Tafeln 2 angezeigt sind. Es ist daher eine bestimmte Darstellung 15 der Tafeln 2 angezeigt. Zudem kann eine nicht näher dargestellte Kennung auf oder bei den Tafeln 2 wie auch bei den Platten 4 angezeigt sein.

In dem oberen in Fig. 4 dargestellten Verfahrensschritt hat der Anwender eine der Platten 4 durch Anklicken ausgewählt und sodann per Drag-And-Drop auf eine der dargestellten Tafeln 2, 15 gezogen. Durch diese Interaktion wird die ausgewählte Platte 4 bzw. deren Abbildung 13 der zuvor genannten Tafel 2 bzw. deren Darstellung 15 zugeordnet. Ein Ausschnitt 19 der Abbildung 13, dessen reale Größe in Bezug auf die Platte 4 der Größe der Oberfläche der zugeordneten Tafel 2 entspricht, wird als Textur der Darstellung 15 der Tafel 2 hinzugefügt und auf der Tafel 2 dargestellt. Zugleich wird der Ausschnitt 19 auf der Abbildung 13 der Platte 4 optisch dargestellt, indem dessen Umrandung als Linie 16 angezeigt wird. Der Bereich außerhalb des Ausschnitts 19 wird in der Darstellung der Vertäfelung 3 je nach Ausgestaltung des Verfahrens angezeigt oder auch nicht. Diese Möglichkeit einer Einblendung ist in Fig. 4 durch die gestrichelt dargestellte Linie 20 angedeutet, welche die Begrenzung der Platte 4 darstellt.

Nachdem die Zuordnung einer Platte 4 zu einer Tafel 2 erfolgt ist, kann der Anwender - wie im mittleren Bild von Fig. 4 gezeigt - mit der graphischen Anzeige 9 der Vertäfelung 3 interagieren und somit den Ausschnitt 19 verschieben und/oder rotieren. In dem gezeigten Beispiel hat der Anwender durch Verwenden der vorgesehenen Handlungen den Ausschnitt 19 auf der Abbildung um 20° im Uhrzeigersinn rotiert und etwas nach links und oben verschoben. Entsprechend wird die Darstellung 15 der Tafel 2 geändert und der geänderte Ausschnitt 19 wird auf der Tafel 2 angezeigt.

Das untere Bild von Fig. 4 zeigt eine Situation, in der der Anwender bereits einige oder sogar alle Zuordnungen von Tafeln 2 zu Ausschnitten 19 der Abbildungen 13 der Platten 4 vorgenommen hat. Gezeigt ist eine Situation, bei der von der linken Platte 4 und der dritten Platte 4 von links jeweils zwei Ausschnitte 19 jeweils einer der Tafeln 2 zugeordnet sind. Der zweiten Platte 4 von links ist eine Tafel 2 zugeordnet und der rechten Platte 4 ist keine Tafel 2 zugeordnet. Die übrigen bereits zugeordneten Tafeln 2 sind Ausschnitten 19 von Abbildungen 13 zugeordnet, die auf der aktuellen Anzeige 9 nicht eingeblendet sind. Es sind allerdings Interaktionsmöglichkeiten vorgesehen, die es einfach ermöglichen, dass auch diese Abbildungen 13 angezeigt werden.

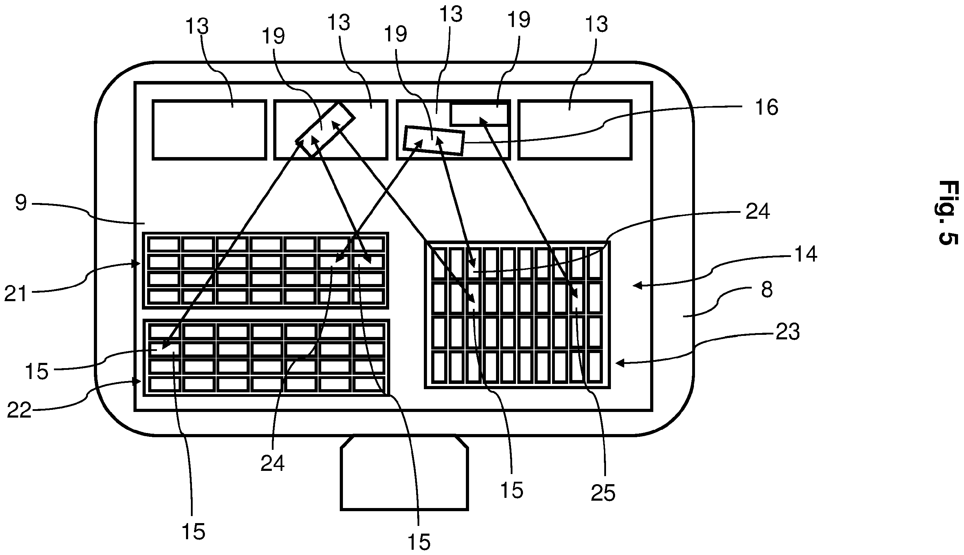

Fig. 5 zeigt eine graphische Anzeige 9, bei der mehrere sich teilweise überlappende Teilflächen bzw. Teilmodelle 21 dargestellt sind. Aufgrund der Überlappung gibt es Tafeln, wie etwa die Tafeln 15 und 24, die mehrfach dargestellt sind. Beispielsweise schließen sich die Teilmodelle 21 und 22 nebeneinander an, wobei die letzte vertikale Reihe des Teilmodells 21 als erste vertikale Reihe in dem Teilmodell 22 enthalten ist. Das Teilmodell 23 wird um 90° gedreht dargestellt, wobei es mehr horizontale, aber weniger vertikale Reihen gibt. Andere Tafeln, wie etwa die Tafel 25, können auch nur einmal dargestellt sein.

Die Tafel 15 ist in allen Teilmodellen 21, 22, 23 enthalten, sodass der der Tafel 15 zugeordnete Ausschnitt 19 der Abbildung 13 einer Platte 4 in allen drei Teilmodellen 21, 22, 23 in der Weise wie zuvor beschrieben dargestellt ist. Wird dann der Ausschnitt 19 durch Interaktion in einem der Teilmodelle 21, 22, 23 verändert, so passt sich der entsprechende Ausschnitt auch in den anderen Teilmodellen 21, 22, 23 automatisch an, in denen die betreffende Tafel 15 enthalten ist. Die Tafel 24 ist von den angezeigten Teilmodellen 21, 22, 23 lediglich in den Teilmodellen 21, 23 enthalten. Die Tafel 25 ist von den angezeigten Teilmodellen 21, 22, 23 nur in dem Teilmodell 23 enthalten. Die Tafel 25 könnte allerdings auch in weiteren, derzeit nicht angezeigten Teilmodellen enthalten sein.

Es müssen nicht sämtliche Teilmodelle 21, 22, 23 angezeigt sein. Der Nutzer kann vielmehr entscheiden, welche Teilmodelle 21, 22, 23 er sich anzeigen lassen möchte.

Der Nutzer kann auch neue Teilmodelle 21, 22, 23 aus dem geometrischen Modell 14 erzeugen. Beispielsweise kann er eine Wandfläche und eine Deckenfläche vollständig oder teilweise zu einer gemeinsamen Fläche vereinigen, um so den Übergang von Wand zur Decke blenden zu können.

Zusammenfassend betrifft die Erfindung ein Verfahren zur Bestimmung von Zuschnittparametern für Platten 4 und ein Verfahren zur Herstellung von Tafeln 2 für eine Vertäfelung 3 einer Fläche 1. Es werden Abbildungen 13 der Platten 4 zusammen mit Größenmaßen derselben sowie ein geometrisches Modell 14 der Vertäfelung 3 bereitgestellt, das zumindest Position, Form und Größe der Tafeln 2 umfasst. Ferner ist vorgesehen, dass den Tafeln 2 jeweils ein deckungsgleicher Ausschnitt 19 einer der Abbildungen 13 zugeordnet wird und dass die Zuschnittparameter durch geometrische Parameter der Ausschnitte 19 gegeben sind. Zur Herstellung der Tafeln 2 werden diese sodann anhand der Zuschnittparameter aus den Platten 4 geschnitten.

### Bezugszeichenliste

- 1: Fläche
- 2: Tafel
- 3: Vertäfelung
- 4: Platte
- 5: Kamera
- 6: Datenleitung
- 7: Computer
- 8: Bildschirm
- 9: Anzeige
- 10: Transportweg
- 11: Schneidmaschine
- 12: Schneidwerkzeug
- 13: Abbildung einer Platte
- 14: Modell einer Vertäfelung
- 15: Darstellung einer Tafel
- 16: Linie
- 17: weiterer Transportweg
- 18: weitere Datenleitung
- 19: Ausschnitt von 13
- 20: Linie
- 21: Teilmodell von 14
- 22: weiteres Teilmodell von 14
- 23: weiteres Teilmodell von 14
- 24: Darstellung einer weiteren Tafel
- 25: Darstellung einer weiteren Tafel

## Patentansprüche

1. Verfahren zur Bestimmung von Zuschnittparametern für Platten (4), wobei Abbildungen (13) der Platten (4) zusammen mit Größenmaßen derselben bereitgestellt werden, wobei ein geometrisches Modell (14) einer Vertäfelung (3) einer Fläche (1) bereitgestellt wird, das zumindest Position, Form und Größe von Tafeln (2, 15, 24, 25) der Vertäfelung (3) umfasst, wobei den Tafeln (2, 15, 24, 25) jeweils ein deckungsgleicher Ausschnitt (19) einer der Abbildungen (13) zugeordnet wird und wobei die Zuschnittparameter durch geometrische Parameter der Ausschnitte (19) gegeben sind, **dadurch gekennzeichnet, dass** die Tafeln (2, 15, 24, 25) jeweils eine eindeutige Kennung erhalten, dass das Modell (14) ein erstes und ein zweites Teilmodell (21, 22, 23) umfasst, die in einem Überlappungsbereich überlappen, und dass in dem Überlappungsbereich die Kennung einer der Tafeln (2, 15, 24, 25) dem ersten und dem zweiten Teilmodell (21, 22, 23) zugeordnet ist.

2. Verfahren nach dem vorangehenden Anspruch, **dadurch gekennzeichnet, dass** die Abbildungen (13) bereitgestellt werden, indem durch eine Messung vorzugsweise von oben ein Abbild der Platten (4) erstellt wird und/oder dass die Größenmaße der Platten (4) gemessen werden, insbesondere wobei die Größenmaße eine Länge und/oder eine Breite der Platten (4) umfassen.

3. Verfahren nach einem der vorangehenden Ansprüche, **dadurch gekennzeichnet, dass** die jeweilige Kennung der Tafeln (2, 15, 24, 25) mit den Zuschnittparametern des zugeordneten Ausschnitts (19) der Abbildungen (13) verknüpft wird und/oder dass die Abbildungen (13) der Platten (4) eine eindeutige Kennung erhalten, die jeweils mit den Zuschnittparametern desjenigen Ausschnitts (19) verknüpft werden, welcher der Abbildung (13) angehört, die die Kennung erhalten hat.

4. Verfahren nach einem der vorangehenden Ansprüche, **dadurch gekennzeichnet, dass** ein Projektzustand, der zumindest die Zuordnungen der Tafeln (2, 15, 24, 25) zu den Abbildungen umfasst, gespeichert wird, insbesondere wobei auf den Projektzustand von verschiedenen Standorten aus vorzugsweise gleichzeitig zugreifbar ist und/oder wobei der Projektzustand gleichzeitig von den verschiedenen Standorten aus änderbar ist.

5. Verfahren nach einem der vorangehenden Ansprüche, **dadurch gekennzeichnet, dass** die Abbildungen (13) angezeigt werden und/oder zumindest Form und Position der Tafeln (2, 15, 24, 25) angezeigt werden und/oder dass der einer Tafel (2, 15, 24, 25) zugeordnete Ausschnitt (19) einer der Abbildungen (13) als Textur auf der Tafel (2, 15, 24, 25) angezeigt wird und/oder dass die Abbildung (13) mittels Drag-And-Drop der Tafel (2, 15, 24, 25) zugeordnet wird.

6. Verfahren nach einem der vorangehenden Ansprüche, **dadurch gekennzeichnet, dass** Begrenzungen von zugeordneten Ausschnitten (19) auf deren jeweiliger Abbildung (13) angezeigt werden, insbesondere durch Anzeigen einer die jeweilige Begrenzung beschreibenden Linie (16), und/oder dass durch eine Interaktion mit einer der angezeigten Tafeln (2, 15, 24, 25) der auf der Tafel (2, 15, 24, 25) angezeigte Ausschnitt (19) der Abbildung (13) verschoben und/oder rotiert wird, insbesondere wobei die Interaktion mit einem Eingabemittel wie etwa einer Computermaus oder einem Berührungssensor ausgelöst wird.

7. Verfahren nach einem der vorangehenden Ansprüche, **dadurch gekennzeichnet, dass** mehr als eine Zuordnung von Tafeln (2, 15, 24, 25) und Ausschnitten (19) computergestützt vorgenommen und angezeigt wird und dass aus den mehreren Zuordnungen eine ausgewählt wird.

8. Verfahren nach einem der vorangehenden Ansprüche, **dadurch gekennzeichnet, dass** eine manuelle und eine rein computergestützte Zuordnung alternierend abwechseln, bis für alle Tafeln (2, 15, 24, 25) Zuordnungen gefunden sind, und/oder dass bei einer Zuordnung einer Tafel (2, 15, 24, 25) zu einem Ausschnitt (19) und/oder bei einer Änderung des Ausschnitts (19) geprüft wird, ob der Ausschnitt (19) oder ein Teil hiervon bereits einer anderen Tafel (2, 15, 24, 25) zugeordnet und/oder außerhalb der zugeordneten Platte (4) liegt, insbesondere wobei eine Aktion ausgelöst wird, wenn dies positiv festgestellt wird, wobei vorzugsweise die Zuordnung und/oder Änderung des Ausschnitts (19) unterbleibt und/oder wobei ein optisches Signal erzeugt wird.

9. Verfahren nach einem der vorangehenden Ansprüche, **dadurch gekennzeichnet, dass** während oder nach, vorzugsweise vollständiger, Zuordnung der Tafeln (2, 15, 24, 25) zu Ausschnitten (19) der Abbildungen (13) computergestützte Zuordnungsanfragen von Tafeln (2, 15, 24, 25), die nicht der Vertäfelung (3) angehören, zu zuordnungsfreien Bereichen der Abbildungen (13) bearbeitet, insbesondere geprüft und akzeptiert, werden und/oder dass Zuordnungen von zumindest manchen oder von allen Tafeln (2, 15, 24, 25) zu Ausschnitten (19) der Abbildungen (13) rein computergestützt erfolgen, insbesondere wobei hierzu Optimierungsverfahren und/oder Verfahren der künstlichen Intelligenz verwendet werden und/oder wobei für die computergestützte Zuordnung Zielkriterien vorgegeben werden.

10. Verfahren nach einem der vorangehenden Ansprüche, **dadurch gekennzeichnet, dass** die Bereitstellung des Modells (14) eine Bereitstellung von Teilmodellen (21, 22, 23) des Modells (14) umfasst oder durch eine solche erfolgt.

11. Verfahren nach einem der vorangehenden Ansprüche, **dadurch gekennzeichnet, dass** in dem Modell (14) die Tafeln (2, 15, 24, 25), insbesondere automatisch, identifiziert und jeweils mit ihrer eindeutigen Kennung versehen werden.

12. Verfahren nach einem der vorangehenden Ansprüche, **dadurch gekennzeichnet, dass** aus dem Modell (14) ein Teilmodell (21, 22, 23) erzeugt wird, insbesondere wobei das Teilmodell (21, 22, 23) eine Kennung einer Tafel (2, 15, 24, 25) umfasst, welche auch einem anderen Teilmodell (21, 22, 23) zugeordnet ist.

13. Verfahren nach einem der vorangehenden Ansprüche, **dadurch gekennzeichnet, dass** zumindest Form und Position mindestens einer der Tafeln (2, 15, 24, 25) mindestens zweifach angezeigt wird, insbesondere als Bestandteil unterschiedlicher Teilmodelle (21, 22, 23) und/oder Darstellungen.

14. Verfahren nach einem der vorangehenden Ansprüche, **dadurch gekennzeichnet, dass** erste Zuschnittparameter zunächst für das erstes Teilmodell (21, 22, 23) bestimmt und zur Herstellung der Tafeln (2, 15, 24, 25) freigegeben werden und dass sodann zweite Zuschnittparameter für das zweites Teilmodell (21, 22, 23) bestimmt werden, wobei das zweite Teilmodell (21, 22, 23) eine Kennung einer gemeinsamen Tafel (2, 15, 24, 25) umfasst, welche auch dem ersten Teilmodell (21, 22, 23) zugeordnet ist, wobei der der gemeinsamen Tafel (2, 15, 24, 25) zugeordnete Ausschnitt (19) einer der Abbildungen (13) bei der Bestimmung der zweiten Zuschnittparameter durch die Freigabe der ersten Zuschnittparameter zur Herstellung der Tafeln (2, 15, 24, 25) unveränderbar festgelegt wird.

15. Verfahren zur Herstellung von Tafeln (2, 15, 24, 25) für eine Vertäfelung (3) einer Fläche (1), wobei die Tafeln (2, 15, 24, 25) aus Platten (4) geschnitten werden, wobei Zuschnittparameter für die Platten (4) durch ein Verfahren nach einem der vorangehenden Ansprüche bestimmt werden und wobei die Tafeln (2, 15, 24, 25) sodann anhand der Zuschnittparameter aus den Platten (4) geschnitten werden, insbesondere wobei die Kennungen der Tafeln (2, 15, 24, 25) auf die geschnittenen Tafeln (2, 15, 24, 25) aufgebracht werden.

## Claims

1. Method for determining blank parameters for slabs (4), wherein image representations (13) of the slabs (4) are provided together with dimensions of same, wherein a geometric model (14) of a panelling (3) of an area (1), is provided, the model comprising at least position, shape and size of panels (2, 15, 24, 25) of the panelling (3), wherein the panels (2, 15, 24, 25) are each assigned a congruent portion (19) of one of the image representations (13) and wherein the blank parameters are given by geometric parameters of the portions (19), **characterized in that** the panels (2, 15, 24, 25) each receive a unique identifier, **in that** the model (14) comprises a first and a second sub-model (21, 22, 23) which overlap in an overlap region, and **in that** the identifier of one of the panels (2, 15, 24, 25) in the overlap region is assigned to the first and the second sub-model (21, 22, 23).

2. Method according to the preceding claim, **characterized in that** the image representations (13) are provided by virtue of an image of the slabs (4) being created by a measurement preferably from above and/or **in that** the dimensions of the slabs (4) are measured, the dimensions in particular comprising a length and/or a width of the slabs (4).

3. Method according to any of the preceding claims, **characterized in that** the respective identifier of the panels (2, 15, 24, 25) is linked with the blank parameters of the assigned portion (19) of the image representations (13) and/or **in that** the image representations (13) of the slabs (4) obtain a unique identifier, each of which is linked to the blank parameters of that portion (19) which belongs to the image representation (13) which has obtained the identifier.

4. Method according to any of the preceding claims, **characterized in that** a project state which at least comprises the assignment of the panels (2, 15, 24, 25) to the image representations is stored, with in particular the project state preferably being accessible from different locations at the same time and/or the project state being modifiable from the different locations at the same time.

5. Method according to any of the preceding claims, **characterized in that** the image representations (13) are displayed and/or at least the shape and position of the panels (2, 15, 24, 25) are displayed and/or **in that** the portion (19) of one of the image representations (13) assigned to a panel (2, 15, 24, 25) is displayed as a texture on the panel (2, 15, 24, 25) and/or **in that** the image representation (13) is assigned to the panel (2, 15, 24, 25) by drag and drop.

6. Method according to any of the preceding claims, **characterized in that** boundaries of assigned portions (19) are displayed on their respective image representation (13), in particular by the display of a line (16) which describes the respective boundary, and/or in that the portion (19) of the image representation (13) displayed on the panel (2, 15, 24, 25) is displaced and/or rotated by an interaction with one of the displayed panels (2, 15, 24, 25), the interaction in particular being triggered using an input means such as, for instance, a computer mouse or a touch sensor.

7. Method according to any of the preceding claims, **characterized in that** more than one assignment of panels (2, 15, 24, 25) and portions (19) is undertaken and displayed in computerized fashion and **in that** one of the plurality of assignments is selected.

8. Method according to any of the preceding claims, **characterized in that** a manual and a purely computerized assignment alternate with one another until assignments have been found for all panels (2, 15, 24, 25) and/or **in that** a check is carried out during an assignment of a panel (2, 15, 24, 25) to a portion (19) and/or during a change of the portion (19) as to whether the portion (19) or a part thereof has already been assigned to another panel (2, 15, 24, 25) and/or is located outside of the assigned slab (4), in particular with an action being triggered if this determination is affirmative, with the assignment and/or change of the portion (19) preferably being omitted and/or an optical signal being generated.

9. Method according to any of the preceding claims, characterized that computerized assignment queries for panels (2, 15, 24, 25), which do not belong to the panelling (3), to unassigned regions of the image representations (13) are processed, in particular checked and accepted, during or after an assignment, preferably a complete assignment, of the panels (2, 15, 24, 25) to the portions (19) of the image representations (13) and/or in that assignments of at least some or all panels (2, 15, 24, 25) to portions (19) of the image representations (13) are implemented in purely computerized fashion, in particular with optimization methods and/or artificial intelligence methods being used to this end and/or with target criteria being specified for the computerized assignment.

10. Method according to any of the preceding claims, **characterized in that** the provision of the model (14) comprises or is implemented by a provision of sub-models (21, 22, 23) of the model (14).

11. Method according to any of the preceding claims, **characterized in that** the panels (2, 15, 24, 25) are identified, in particular automatically, in the model (14) and are each provided with their unique identifier.

12. Method according to any of the preceding claims, **characterized in that** a sub-model (21, 22, 23) is generated from the model (14), with the sub-model (21, 22, 23) in particular comprising an identifier of a panel (2, 15, 24, 25) which is also assigned to a different sub-model (21, 22, 23).

13. Method according to any of the preceding claims, **characterized in that** at least the shape and position of at least one of the slabs (2, 15, 24, 25) is displayed at least twice, in particular as a constituent part of different sub-models (21, 22, 23) and/or representations.

14. Method according to any of the preceding claims, **characterized in that** the first blank parameters are initially determined for the first sub-model (21, 22, 23) and approved for the production of the panels (2, 15, 24, 25) and **in that** subsequently second blank parameters are determined for the second sub-model (21, 22, 23), the second sub model (21, 22, 23) comprising an identifier of a common panel (2, 15, 24, 25) which is also assigned to the first sub-model (21, 22, 23), with the portion (19) of one of the image representations (13) assigned to the common panel (2, 15, 24, 25) being fixedly defined during the determination of the second blank parameters by approving the first blank parameters for producing the panels (2, 15, 24, 25).

15. Method for producing panels (2, 15, 24, 25) for a panelling (3) of an area (1), wherein the panels (2, 15, 24, 25) are cut from slabs (4), wherein the blank parameters for the slabs (4) are determined by a method according to any of the preceding claims and wherein the panels (2, 15, 24, 25) are then cut from the slabs (4) on the basis of the blank parameter, in particular wherein the identifiers of the panels (2, 15, 24, 25) are applied to the cut panels (2, 15, 24, 25).

## Revendications

1. Procédé de détermination de paramètres de coupe pour des panneaux (4), dans lequel des représentations (13) des panneaux (4) sont fournies en même temps que des dimensions de ceux-ci, dans lequel un modèle géométrique (14) d'un assemblage (3) d'une surface (1) est fourni, qui comprend au moins la position, la forme ainsi que les dimensions des panneaux (2, 15, 24, 25) de l'assemblage (3), dans lequel une section (19) qui correspond à l'une des représentations (13) est associée à chaque panneau (2, 15, 24, 25), et dans lequel les paramètres de coupe sont donnés par des paramètres géométriques des sections (19), **caractérisé en ce que** les panneaux (2, 15, 24, 25) reçoivent chacun un identifiant unique, **en ce que** le modèle (14) comprend un premier et un second modèles partiels (21, 22, 23) qui se chevauchent dans une zone de chevauchement, et **en ce que**, à l'intérieur de la zone de chevauchement, l'identifiant de l'un des panneaux (2, 15, 24, 25) est associé au premier et au second modèles partiels (21, 22, 23).

2. Procédé selon la revendication précédente, **caractérisé en ce que** les représentations (13) sont fournies en produisant, en procédant à une mesure, de préférence par le dessus, d'une image des panneaux (4), et/ou **en ce que** les dimensions des panneaux (4) sont mesurées, en particulier dans lequel les dimensions comprennent une longueur et/ou une largeur des panneaux (4).

3. Procédé selon l'une quelconque des revendications précédentes, **caractérisé en ce que** l'identifiant respectif des panneaux (2, 15, 24, 25) est associé aux paramètres de coupe de la section associée (19) des représentations (13), et/ou **en ce que** les représentations (13) des panneaux (4) reçoivent un identifiant unique qui est associé respectivement aux paramètres de coupe de la section (19) qui appartient à la représentation (13) qui a reçu l'identifiant.

4. Procédé selon l'une quelconque des revendications précédentes, **caractérisé en ce qu'**un état de projet qui inclut au moins les associations des panneaux (2, 15, 24, 25) aux représentations est mémorisé, en particulier dans lequel l'état de projet est accessible de préférence de façon simultanée à partir de différents sites et/ou dans lequel l'état de projet peut être modifié de façon simultanée à partir de différents sites.

5. Procédé selon l'une quelconque des revendications précédentes, **caractérisé en ce que** les représentations (13) sont affichées et/ou au moins la forme et la position des panneaux (2, 15, 24, 25) sont affichées, et/ou **en ce que** la section (19) de l'une des représentations (13) associée à un panneau (2, 15, 24, 25) est affichée sous forme de texture sur le panneau (2, 15, 24, 25), et/ou **en ce que** la représentation (13) est associée au panneau (2, 15, 24, 25) par l'intermédiaire d'une fonction de type glisser-déposer.

6. Procédé selon l'une quelconque des revendications précédentes, **caractérisé en ce que** des sections (19) sont affichées sur des délimitations de leurs représentations associées respectives (13), en particulier en affichant une ligne (16) qui décrit la délimitation respective, et/ou **en ce que**, par l'intermédiaire d'une interaction avec l'un des panneaux affichés (2, 15, 24, 25), la section (19) de la représentation (13) affichée sur le panneau (2, 15, 24, 25) est déplacée et/ou pivotée, dans lequel l'interaction est en particulier déclenchée par un moyen d'entrée tel qu'une souris d'ordinateur ou un capteur tactile.

7. Procédé selon l'une quelconque des revendications précédentes, **caractérisé en ce que** plusieurs associations de panneaux (2, 15, 24, 25) et de sections (19) sont réalisées et affichées à l'aide d'une assistance informatique, et **en ce qu'**une association est sélectionnée parmi les multiples associations.

8. Procédé selon l'une quelconque des revendications précédentes, **caractérisé en ce qu'**une association manuelle et une association entièrement assistée par ordinateur alternent jusqu'à ce qu'une association soit trouvée pour chacun des panneaux (2, 15, 24, 25), et/ou **en ce que**, lors de l'association d'un panneau (2, 15, 24, 25) à une section (19) et/ou lors de la modification de la section (19), on vérifie si la section (19) ou une partie de celle-ci a déjà été associée à autre panneau (2, 15, 24, 25) et/ou se trouve en dehors du panneau associé (4), en particulier dans lequel, en cas de détermination positive de l'une de ces situations, une action est déclenchée et l'association et/ou la modification de la section (19) est/sont de préférence omise(s) et/ou un signal optique est généré.

9. Procédé selon l'une quelconque des revendications précédentes, **caractérisé en ce que**, pendant ou après l'association, de préférence complète, des panneaux (2, 15, 24, 25) à des sections (19) des représentations (13), des demandes d'association assistées par ordinateur de panneaux (2, 15, 24, 25) qui n'appartiennent pas à l'assemblage (3) à des régions exemptes d'association des représentations (13) sont traitées, en particulier vérifiées et acceptées, et/ou **en ce que** des associations d'au moins plusieurs voire la totalité des panneaux (2, 15, 24, 25) à des sections (19) des représentations (13) sont réalisées de façon entièrement assistée par ordinateur, en particulier en utilisant à cet effet des procédés d'optimisation et/ou des procédés d'intelligence artificielle et/ou en prédéfinissant des critères cibles prescrits pour la réalisation des associations assistées par ordinateur.

10. Procédé selon l'une quelconque des revendications précédentes, **caractérisé en ce que** la mise à disposition du modèle (14) comprend une mise à disposition de modèles partiels (21, 22, 23) du modèle (14) ou est réalisée par l'intermédiaire d'une mise à disposition de ce type.

11. Procédé selon l'une quelconque des revendications précédentes, **caractérisé en ce que**, dans le modèle (14), les panneaux (2, 15, 24, 25) sont identifiés, en particulier automatiquement, et sont chacun pourvus de leur identifiant unique.

12. Procédé selon l'une quelconque des revendications précédentes, **caractérisé en ce qu'**un modèle partiel (21, 22, 23) est généré à partir du modèle (14), en particulier dans lequel le modèle partiel (21, 22, 23) comprend un identifiant d'un panneau (2, 15, 24, 25) qui est également associé à un autre modèle partiel (21, 22, 23).

13. Procédé selon l'une quelconque des revendications précédentes, **caractérisé en ce qu'**au moins la forme et la position d'au moins un des panneaux (2, 15, 24, 25) sont affichées au moins deux fois, en particulier en tant que partie intégrante de différents modèles partiels (21, 22, 23) et/ou représentations.

14. Procédé selon l'une quelconque des revendications précédentes, **caractérisé en ce que** des premiers paramètres de coupe sont d'abord déterminés pour le premier modèle partiel (21, 22, 23) et sont validés pour la fabrication des panneaux (2, 15, 24, 25), et **en ce que** des seconds paramètres de coupe sont ensuite déterminés pour le second modèle partiel (21, 22, 23), dans lequel le second modèle partiel (21, 22, 23) comprend un identifiant d'un panneau commun (2, 15, 24, 25) qui est également associé au premier modèle partiel (21, 22, 23), et dans lequel la section (19) de l'une des représentations (13) associée au panneau commun (2, 15, 24, 25) est établie de façon inchangeable lors de la détermination des seconds paramètres de coupe par la validation des premiers paramètres de coupe pour la fabrication des panneaux (2, 15, 24, 25).

15. Procédé de fabrication de panneaux (2, 15, 24, 25) pour un assemblage (3) d'une surface (1), dans lequel les panneaux (2, 5, 15, 24, 25) sont découpés à partir de plaques (4), dans lequel des paramètres de coupe des plaques (4) sont déterminés en utilisant un procédé selon l'une quelconque des revendications précédentes, dans lequel les panneaux (2, 5, 24, 25) sont découpés ensuite à partir des plaques (4) sur la base des paramètres de coupe, et en particulier dans lequel les identifiants des panneaux (2, 15, 24, 25) sont appliqués sur les panneaux découpés (2, 15, 24, 25).
